# EUROPEAN PATENT APPLICATION

(11) **EP 4 633 328 A1**
(43) Date of publication of application: **15.10.2025**
(21) Application number: 24887745.8
(22) Date of filing: 22.10.2024
(51) Int. Cl.: H10F 10/161, H10F 10/19

(54) **MULTI-JUNCTION SOLAR CELL AND PREPARATION METHOD THEREFOR, AND ELECTRONIC DEVICE**

(30) Priority: 10.11.2023 CN 202311495728
(71) Applicant: YANGZHOU CHANGELIGHT CO., LTD., Yangzhou, Jiangsu 225009 (CN)
(72) Inventor: WU, Zhenlong, Yangzhou, Jiangsu 225009 (CN)
(74) Representative: Michalski Hüttermann & Partner Patentanwälte mbB
(86) International application number: PCT/CN2024/126372
(87) International publication number: WO 2025/098132

(57) **Abstract**

The present disclosure relates to a multi-junction solar cell, a preparation method thereof, and an electronic device. The multi-junction solar cell, includes at least one heterojunction subcell, wherein the bandgap Ega of the base region of the heterojunction subcell is greater than the bandgap Egb of the emitter region, and the bandgap Egc of the undoped layer lies between the bandgaps of the base region and the emitter region. This configuration effectively prevents redistribution of dopant impurities within the subcell, ensuring the performance and efficiency of the solar cell, and thereby achieves a multijunction solar cell with high efficiency and superior performance.

## Description

The present application claims priority to Chinese patent Application No. 202311495728.1, filed with the Chinese Patent Office on November 10, 2023 and entitled "MULTI-JUNCTION SOLAR CELL AND PREPARATION METHOD THEREFOR, AND ELECTRONIC DEVICE," the entire disclosures of which are incorporated herein by reference for all purposes.

### TECHNICAL FIELD

The present disclosure is related to the technical field of solar cells, and more particularly, to a multi-junction solar cell, a preparation method thereof, and an electronic device employing the same.

### BACKGROUND

As one of the most efficient forms of clean energy, solar cells can directly convert solar energy into electrical energy. Among existing material systems, the solar cells with the highest conversion efficiency are III-V group compound semiconductor solar cells. These solar cells also exhibit excellent high-temperature resistance and strong radiation resistance, and are widely recognized as the next-generation high-performance, long-lifespan primary power source for space applications.

Currently, research is primarily focused on bandgap-matched GaInP/GaAs/InGaAs triple-junction solar cells. Under high-concentration illumination conditions, their theoretical efficiency can reach up to 50%. However, due to lattice mismatch between the different material layers, the actual material growth process tends to introduce a significant number of defects. As a result, the bandgap-matched GaInP/GaAs/InGaAs triple-junction solar cells exhibit relatively low actual device efficiency.

To address the above problem, existing technologies employ inverted growth techniques, wherein a graded buffer layer is introduced between subcells with lattice mismatch, in order to reduce dislocation density and improve crystal quality. However, in these inverted-growth triple-junction solar cells, the need to grow lattice-mismatched buffer layers for stress release and dislocation reduction leads to prolonged growth time. Furthermore, the growth of subsequent subcells effectively acts as an annealing process for the previously grown subcells, resulting in redistribution of dopants within the subcells and ultimately affecting the performance and efficiency of the triple-junction solar cell.

### SUMMARY OF THE INVENTION

To solve the above problems, the present disclosure provides a multi-junction solar cell, a preparation method thereof, and an electronic device that uses the cell, with the aim of achieving high performance and high efficiency.

According to a first aspect of the present disclosure, a multijunction solar cell is provided, comprising at least one heterojunction subcell, wherein the heterojunction subcell includes:
a window layer, an emitter region, an undoped layer, a base region, and a back surface field (BSF) layer.
In the heterojunction subcell, the bandgap Ega of the base region is greater than the bandgap Egb of the emitter region, and the undoped layer is disposed between the base region and the emitter region, where the bandgap Egc of the undoped layer satisfies: Egb≤Egc≤Ega, Ega≠Egb.

Optionally, in the heterojunction subcell:
the thickness of the emitter region is greater than that of the base region and the BSF layer, and the thickness of the BSF layer is greater than that of the base region.
the emitter region is N-type doped, the base region is P-type doped, and the doping concentration of the emitter is less than that of the base region.

Optionally, in the heterojunction subcell:
the BSF layer is P-type doped, and its doping concentration is greater than that of the base region, and the bandgap Egd of the BSF layer is greater than Ega.

Optionally, the thickness of an emitter region exceeds 500 nm, the thickness of the BSF layer is less than 400 nm, the thickness of the base region is less than 200 nm, and the thickness of the undoped layer is greater than 50 nm.

Optionally, the multi-junction solar cell comprises a plurality of heterojunction subcells, wherein each of the heterojunction subcells is composed of different materials, and in any of the heterojunction subcells:
a window layer made of N-AlInP,
an emitter region made of N-AlGaInP,
an undoped layer made of I-AlGaInP,
a base region made of P-AlGaInP, and
a BSF layer made of P-AlGaInP.

Optionally, the multi-junction solar cell comprises a plurality of heterojunction subcells, wherein each of the heterojunction subcells is composed of different materials, and in any of the heterojunction subcells:
a window layer made of GaInP, AlGaInP, or AlInP;
an emitter region made of N-AlGaAs;
an undoped layer made of I-AlGaAs; and
a base region and BSF layer made of P-AlGaAs or P-GaInP.

Optionally, the multi-junction solar cell comprises a plurality of heterojunction subcells, wherein each of the heterojunction subcells is composed of different materials, and in any of the heterojunction subcells:
a window layer made of GaInP or AlGaInP;
an emitter region made of N-AlGaAs or N-GaInP;
a BSF layer made of AlInGaAs, and
a base region made of P-InGaAs.

According to a second aspect of the present disclosure, a preparation method for a multi-junction solar cell is provided, comprising the steps of:
providing a substrate;
using a metal-organic chemical vapor deposition (MOCVD) process to sequentially grow on the substrate an etch stop layer, an N-type ohmic contact layer, at least one subcell group including at least one heterojunction subcell, and a P-type ohmic contact layer, a multijunction solar cell is provided, comprising at least one heterojunction subcell;
wherein the heterojunction subcell includes, a window layer, an emitter region, an undoped layer, a base region, and a back surface field (BSF) layer.

In the heterojunction subcell, the bandgap Ega of the base region is greater than the bandgap Egb of the emitter region, and the undoped layer is disposed between the base region and the emitter region, where the bandgap Egc of the undoped layer satisfies: Egb≤Egc≤Ega , Ega≠Egb.

Optionally, when growing the heterojunction sub-cell using MOCVD, the thickness of the emitter region of the heterojunction sub-cell is controlled to exceed the thickness of the base region and the BSF layer, and the thickness of the BSF layer exceeds the thickness of the base region.
wherein, the emitter region is N-type doped, the base region is P-type doped, and the doping concentration of the emitter is lower than that of the base.

Optionally, when growing the heterojunction sub-cell using MOCVD, the BSF layer is P-type doped, and the doping concentration is higher than that of the base region, with the bandgap Egd of the BSF layer greater than Ega.

According to a third aspect of the present disclosure, an electronic device is provided, comprising the multi-junction solar cell as described above, or a multi-junction solar cell prepared using the method described above.

Based on the above embodiment of the present disclosure, a multi-junction solar cell, its preparation method, and an electronic device are provided. The multi-junction solar cell includes at least one heterojunction subcell. The heterojunction subcell comprises: a window layer, an emitter region, an undoped layer, a base region, and a BSF layer. The bandgap Ega of the base region in the heterojunction subcell is greater than the bandgap Egb of the emitter region. An undoped layer is arranged between the base region and the emitter region, and the bandgap Egc of the undoped layer satisfies the relationship: Egb≤Egc≤Ega, and Ega ≠ Egb. In the embodiment of the present disclosure, at least one heterojunction subcell is grown during the preparation process of the multi-junction solar cell, such that the bandgap Ega of the base region is greater than the bandgap Egb of the emitter region, and the bandgap Egc of the undoped layer lies between Ega and Egb. This design can effectively prevent the redistribution of dopants within the subcell, thereby ensuring the performance and efficiency of the solar cell, and ultimately achieving the goal of a multi-junction solar cell with high efficiency and performance.

### DESCRIPTION OF THE DRAWINGS

In order to more clearly illustrate the technical solutions in the embodiments of the present disclosure or in the related art, the accompanying drawings that are required in the description of the embodiments or existing technologies are briefly introduced below. It is evident that the drawings described below are merely examples of embodiments of the present disclosure. For those skilled in the art, other drawings can also be derived based on the provided figures without creative efforts.

The structures, proportions, dimensions, etc., depicted in the figures of this specification are provided solely to aid in the explanation of the content disclosed in the specification, so that those skilled in the art may understand and read it. They are not intended to limit the conditions under which the present disclosure may be implemented and thus do not hold any technical significance. Any structural modifications, changes in proportional relationships, or adjustments in dimensions should fall within the scope of the technical content disclosed in this application as long as they do not affect the efficacy or intended purpose of the application.
FIG. 1 is a schematic structural diagram of a multi-junction solar cell disclosed in an embodiment of the present disclosure.
FIG. 2 is another schematic structural diagram of a multi-junction solar cell disclosed in an embodiment of the present disclosure.
FIG. 3 is yet another schematic structural diagram of a multi-junction solar cell disclosed in an embodiment of the present disclosure.
FIG. 4 is still another schematic structural diagram of a multi-junction solar cell disclosed in an embodiment of the present disclosure.
FIG. 5 is a further schematic structural diagram of a multi-junction solar cell disclosed in an embodiment of the present disclosure.

The referenced components include: substrate (1), etch stop layer (2), N-type ohmic contact layer (3), first subcell (4), first window layer (41), first emitter region (42), first base region (43), first BSF layer (44), first tunnel junction (5), first N-type layer (51), first P-type layer (52), second subcell (6), second window layer (61), second emitter region (62), second base region (63), second BSF layer (64), second tunnel junction (7), second N-type layer (71), second P-type layer (72), metamorphic buffer layer (8), third subcell (9), third window layer (91), third emitter region (92), third base region (93), third BSF layer (94), and P-type ohmic contact layer (10).

### DETAILED DESCRIPTION OF THE DISCLOSURE

The embodiments of the present disclosure will now be described clearly and completely with reference to the accompanying drawings. It should be understood that the described embodiments are only a portion of all possible embodiments of the present disclosure, and not exhaustive. All other embodiments obtained by those skilled in the art based on the embodiments of the present disclosure without creative efforts shall fall within the scope of protection of the present disclosure.

To make the above objectives, features, and advantages of the present disclosure more apparent and easier to understand, the present disclosure is further described in detail below in conjunction with the drawings and specific embodiments.

In existing technologies, inverted growth techniques are used, wherein a graded buffer layer is introduced between subcells with lattice mismatch to reduce the dislocation density and improve the crystal quality of the material. However, in triple-junction solar cells grown using current inverted growth techniques, the required growth of lattice-mismatched buffer layers to relieve stress and reduce dislocations leads to long growth times. The growth of subsequent subcells essentially acts as an annealing process for the previously grown subcells, resulting in the redistribution of dopants within the subcells and ultimately degrading the performance and efficiency of the triple-junction solar cell. Therefore, an embodiment of the present disclosure discloses a new type of multi-junction solar cell. During the growth process of the multi-junction solar cell, at least one heterojunction subcell is formed, wherein the bandgap Ega of the base region is greater than the bandgap Egb of the emitter region, and the bandgap Egc of the undoped layer is between Ega and Egb. This design can effectively prevent the redistribution of dopants within the subcell, thereby ensuring the performance and efficiency of the solar cell and achieving the goal of a multi-junction solar cell with high efficiency and performance.

An embodiment of the present disclosure discloses a multi-junction solar cell that includes at least one heterojunction subcell. The heterojunction subcell includes: a window layer, an emitter region, an undoped layer, a base region, and a BSF layer.

In the heterojunction subcell, the bandgap Ega of the base region is greater than the bandgap Egb of the emitter region, and the undoped layer is disposed between the base region and the emitter region, where the bandgap Egc of the undoped layer satisfies: Egb≤Egc≤Ega, Ega≠Egb.

In some embodiments of the present disclosure, within the heterojunction subcell, the thickness of the emitter region is greater than that of both the base region and the BSF layer, and the BSF layer is thicker than the base region.

In an embodiment of the present disclosure, the thicknesses of the emitter, base, and BSF layers are all different. Specifically, the emitter region is thicker than both the base region and the BSF layer, and the BSF layer is thicker than the base region.

The emitter region is N-type doped, while the base region is P-type doped. The doping concentration of the emitter region is lower than that of the base region.

Preferably, the emitter region has a thickness greater than 500 nm, the BSF layer has a thickness less than 400 nm, the base region has a thickness less than 200 nm, and the undoped layer has a thickness greater than 50 nm.

In some embodiments of the present disclosure, the BSF layer in the heterojunction subcell is P-type doped, with a doping concentration higher than that of the base region.

Preferably, the bandgap Egd of the BSF layer is greater than Ega.

In the embodiments of the present disclosure, by configuring the thickness relationship between the base region and the BSF layer as described above, the depletion region can be extended partially into the BSF layer, thereby increasing the device voltage of the multi-junction solar cell.

In some embodiments, when the multi-junction solar cell includes multiple subcells, the constituent materials of the subcells differ, and at least one of the subcells is a heterojunction subcell.

Preferably, for subcells primarily made of AlGaInP or GaAs materials, the base region is made of AlGaInP doped with Zn or AlGaAs doped with C.

Preferably, the primary materials used to form the subcells include, but are not limited to, AlGaInP, GaAs, or InGaAs.

In some embodiments, any subcell or heterojunction subcell is made of AlGaInP-based material;
a window layer is made of N-AlInP,
an emitter region is made of N-AlGaInP,
an undoped layer is made of I-AlGaInP,
a base region is made of P-AlGaInP, and
a BSF layer is made of P-AlGaInP.

In some embodiments, any subcell or heterojunction subcell is made of GaAs-based material;
a window layer is made of GaInP, AlGaInP, or AlInP;
an emitter region is made of N-AlGaAs;
an undoped layer is made of I-AlGaAs;
a base region is made of P-AlGaAs or P-GaInP; and
a BSF layer is made of P-AlGaAs or P-GaInP.

In some embodiments, any subcell or heterojunction subcell is made of INGaAs-based material;
a window layer made of GaInP or AlGaInP;
an emitter region made of N-AlGaAs or N-GaInP;
a base region made of P-InGaAs; and
a BSF layer made of GaInP or AlInGaAs.

For example, when the multi-junction solar cell includes two subcells, both subcells may be heterojunction subcells made of different materials, or only one of the subcells may be a heterojunction subcell, and this heterojunction subcell and the other subcell may also be made of different materials.

For example, when the multi-junction solar cell includes three subcells, all three subcells may be heterojunction subcells made of different materials, or only one or two of the subcells may be heterojunction subcells, and the heterojunction subcells and the remaining subcells may also be made of different materials.

In the embodiment of the present disclosure, at least one heterojunction subcell is grown is included in the multi-junction solar cell, such that the bandgap Ega of the base region is greater than the bandgap Egb of the emitter region, and the bandgap Egc of the undoped layer lies between Ega and Egb. This design can effectively prevent the redistribution of dopants within the subcell, thereby ensuring the performance and efficiency of the solar cell, and ultimately achieving the goal of a multi-junction solar cell with high efficiency and performance.

The following provides an illustrative example in which the multi-junction solar cell includes three subcells.

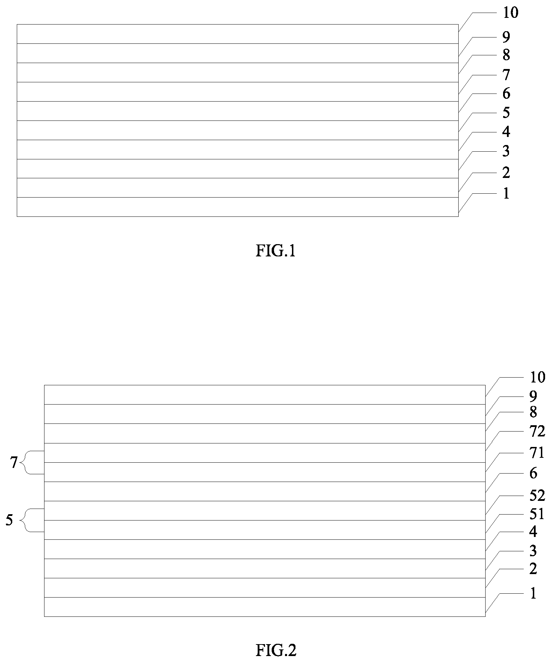

As shown in FIG. 1, the multi-junction solar cell includes:
a substrate (1), and sequentially grown on the substrate an etch stop layer (2), an N-type ohmic contact layer (3), a first subcell (4), a first tunnel junction (5), a second subcell (6), a second tunnel junction (7), a metamorphic buffer layer (8), a third subcell (9), and a P-type ohmic contact layer (10).

Among these, at least one or two of the first subcell (4), the second subcell (6) and the third subcell (9) are heterojunction subcells.

Among these, the first subcell (4) is an AlGaInP-based subcell; the second subcell (6) is a GaAs-based subcell; the third subcell (9) is an InGaAs-based subcell.

Wherein, the first subcell (4) and second subcell (6) are connected via the first tunnel junction (5), while the second subcell (6) and third subcell (9) are connected via the second tunnel junction (7).

In any of the subcells (4, 6, or 9), or in all of them, the thickness of the base region is smaller than that of the emitter region and the BSF layer.

In some embodiments of the present disclosure, the layers described above are sequentially grown on the substrate (1) using MOCVD, including: stop layer (2), N-type ohmic contact layer (3), first subcell (4), first tunnel junction (5), second subcell (6), second tunnel junction (7), metamorphic buffer layer (8), third subcell (9), and P-type ohmic contact layer (10).

In some embodiments, the emitter regions in the first, second, and third subcells (4, 6, and 9) are N-type doped, the base regions are P-type doped, and the BSF layers are also P-type doped. The P-type doping concentration of the base regions is lower than that of the BSF layers.

In some embodiments, for any one or two of the first, second, and third subcells (4, 6, and 9), the thickness of the emitter region is greater than that of the base and BSF layers, the base region is thinner than the BSF layer, and the bandgap of the BSF layer is greater than that of the base region.

Preferably, the thickness of an emitter region exceeds 500 nm, the thickness of the BSF layer is less than 400 nm, the thickness of the base region is less than 200 nm, and the thickness of the undoped layer is greater than 50 nm.

In some embodiments of the present disclosure, the N-GaAs layer grown on the etch stop layer 2 is used as the N-type ohmic contact layer 3.

In some embodiments of the present disclosure, as shown in FIG. 2, the first tunnel junction 5 includes a first N-type layer 51 and a first P-type layer 52.

The N-GaAs layer or N-GaInP layer grown on the first subcell 4 serves as the first N-type layer 51 of the first tunnel junction 5.

The P-AlGaAs layer grown on the first N-type layer 51 serves as the first P-type layer 52 of the first tunnel junction 5.

The N-type dopant in the first N-type layer 51 includes Si or Te; the P-type dopant in the first P-type layer 52 includes C.

In some embodiments of the present disclosure, as shown in FIG. 2, the second tunnel junction 7 includes a second N-type layer 71 and a second P-type layer 72.

The N-GaAs layer or N-GaInP layer grown on the second subcell 6 serves as the second N-type layer 71.

The P-AlGaAs material grown on the second N-type layer 71 serves as the second P-type layer 72.

The N-type dopant in the second N-type layer 71 includes Si or Te; the P-type dopant in the second P-type layer 72 includes C.

In some embodiments of the present disclosure, the metamorphic buffer layer 8 is made of AlGaInAs or GaInP material.

The metamorphic buffer layer 8 includes at least three sequential layers, each having a lattice constant that increases along the direction from the second subcell 6 to the third subcell 9. Each layer has a lattice constant greater than that of the second subcell 6.

In some embodiments of the present disclosure, at least one layer in the metamorphic buffer layer 8 is an overshooter layer whose lattice constant is greater than that of the third subcell 9.

For example:
the metamorphic buffer layer 8 includes at least five layers in sequence: L1, L2, L3, L4, and L5, with corresponding lattice constants aL1, aL2, aL3, aL4, and aL5. Let the lattice constant of the second subcell 6 be a2.

Each of the five layers has a lattice constant greater than a2 and increases along the direction toward the third subcell 9: that is, aL1 < aL2 < aL3 < aL4 < aL5.

At least one of these layers is an overshooter layer, which has a lattice constant a1 greater than the lattice constant a3 of the third subcell 9.

In some embodiments, a P-AlInGaAs or P-InGaAs layer grown on the third subcell 9 serves as the P-type ohmic contact layer 10, which forms an ohmic contact with the electrode.

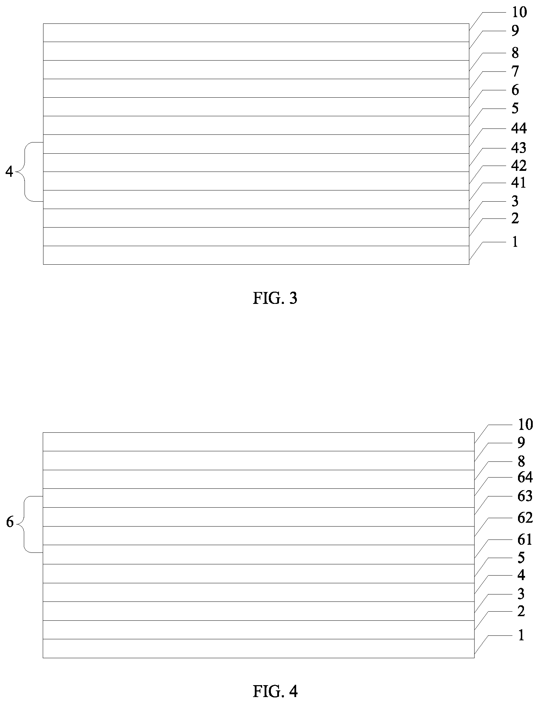

In some embodiments of the present disclosure, as shown in FIG. 3, the first subcell 4 includes, from bottom to top, a first window layer 41, a first emitter region 42, an undoped layer, a first base region 43, and a first BSF layer 44.

Wherein, the first window layer 41 is made of N-AlInP material.

The first emitter region 42 is made of N-AlGaInP. The first base region 43 is made of P-AlGaInP.

The first BSF layer 44 is made of P-AlGaInP.

Preferably, if the first subcell 4 is a heterojunction subcell, an undoped layer made of I-AlGaInP is placed between the first emitter region 42 and the first base region 43.

Alternatively, if the first subcell 4 is a heterojunction subcell, an undoped (undoped) layer made of AlGaAs or GaInP material is also provided between the first emitter region 42 and the first base region 43., where the bandgap Egc of the undoped layer satisfies: Egb≤Egc≤Ega, Ega#Egb.

Wherein, the thickness of the first base region 43 is less than that of both the first emitter region 42 and the first BSF layer 44. The first emitter region 42 is thicker than the first BSF layer 44. The bandgap of the first BSF layer 44 is greater than that of the first base region 43.

Preferably, the first emitter region 42 is thicker than 500 nm, the first BSF layer 44 is thinner than 400 nm, the first base region 43 is thinner than 200 nm, and the undoped layer is thicker than 50 nm.

Specifically, the first emitter region 42 is 600 nm thick, the first BSF layer 44 is 300 nm thick, the first base region 43 is 150 nm thick, and the undoped layer is 55 nm thick.

Preferably, the first emitter region 42 is N-type doped, the first base region 43 and the first BSF layer 44 are P-type doped, and the P-type doping concentration of the first base region 43 is lower than that of the first BSF layer 44.

Optionally, the P-type doping of the first base region 43 is low-doped, where "low-doped" means a doping concentration less than 2e17cm-3.

In an embodiment of the present disclosure of the present disclosure, as shown in FIG. 4, the second subcell 6 includes, from bottom to top: a second window layer 61, a second emitter region 62, a second base region 63, and a second BSF layer 64.

Wherein, the second window layer 61 is made of GaInP, AlGaInP, or AlInP.

The second emitter region 62 is made of N-AlGaAs.

The second base region 63 is made of P-AlGaAs or P-GaInP.

The second BSF layer 64 is made of P-AlGaAs or P-GaInP.

Preferably, if the second subcell 6 is a heterojunction subcell, an undoped layer made of I-AlGaInP, AlGaAs.

Or, GaInP is provided between the second emitter region 62 and the second base region 63.

The bandgap of the undoped layer satisfies: Egb≤Egc≤Ega, and Ega≠Egb.

Wherein, the second base region 63 is thinner than both the second emitter region 62 and the second BSF layer 64. The second emitter region 62 is thicker than the second BSF layer 64. The second BSF layer 64 has a higher bandgap than the second base region 63.

Preferably, the second emitter region 62 is thicker than 500 nm, the second BSF layer 64 is thinner than 400 nm, the second base region 63 is thinner than 200 nm, and the undoped layer is thicker than 50 nm. Specifically, the second emitter region 62 is 550 nm thick, the second BSF layer 64 is 300 nm thick, the second base region 63 is 150 nm thick, and the undoped layer is 55 nm thick.

Preferably, the second emitter region 62 is N-type doped, the second base region 63 and the second BSF layer 64 are P-type doped, and the P-type doping concentration of the second base region 63 is lower than that of the second BSF layer 64.

Optionally, the second base region 63 is low-doped, defined as a doping concentration below 2e17cm-3.

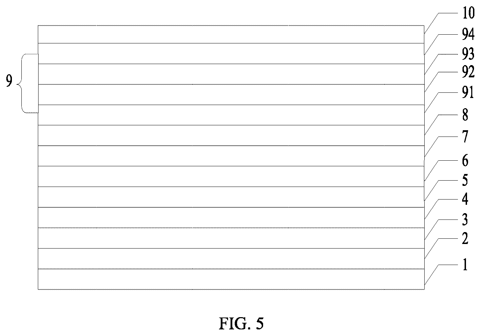

In an embodiment of the present disclosure of the present disclosure, as shown in FIG. 5, the third subcell 9 includes, from bottom to top: a third window layer 91, an N-InGaAs or N-GaInP emitter region 92, a P-InGaAs base region 93, and a third BSF layer 94.

The third BSF layer 94 is made of GaInP or AlInGaAs; the third window layer 91 is also made of GaInP or AlInGaAs.

In some embodiments, as shown in FIG. 3, the third subcell 9 includes, from bottom to top: a third window layer 91, a third emitter region 92, a third base region 93, and a third BSF layer 94.

The third window layer 91 is made of GaInP or AlInyGaAs.

The third emitter region 92 is made of N-InyGaAs or N-GaInP.

The third base region 93 is made of P-InyGaAs.

The third BSF layer 94 is made of GaInP or AlInyGaAs.

Preferably, the third emitter region 92 is N-type doped, the third base region 93 and third BSF layer 94 are P-type doped, and the P-type doping concentration of the third base region 93 is lower than that of the third BSF layer 94.

Optionally, the third base region 93 is low-doped, i.e., with a doping concentration below 2e17cm-3.

It should be noted that if the third subcell 9 is a heterojunction subcell, then an undoped layer must also be provided between the third emitter region 92 and the third base region 93. The bandgap of this undoped layer must satisfy the relationship: Egb≤Egc≤Ega and Ega≠Egb.

In the multi-junction solar cell disclosed in the embodiments of the present disclosure, at least one heterojunction subcell is included. The bandgap Ega of the base region is greater than the bandgap Egb of the emitter region. The undoped layer's bandgap Egc is between Ega and Egb, enabling the depletion region to extend into the higher-bandgap base region, reducing non-radiative recombination, and thereby increasing device voltage. Additionally, the thick emitter design helps lower series resistance. This prevents dopant redistribution in the subcell, ensuring performance and efficiency, and achieves a high-efficiency, high-performance multi-junction solar cell.

Furthermore, by configuring the thickness relationship between the base and BSF layers, the depletion region can extend partially into the BSF layer, further increasing device voltage.

The present disclosure also provides a preparation method for a multi-junction solar cell, which can produce the cell described above. The preparation method includes the following steps:
S11: Provide a substrate.
S12: Using MOCVD, sequentially grow an etch stop layer, an N-type ohmic contact layer, at least one subcell group, including at least one heterojunction subcell, and a P-type ohmic contact layer on the substrate.
wherein the heterojunction subcell includes, a window layer, an emitter region, an undoped layer, a base region, and a back surface field (BSF) layer.

In the heterojunction subcell, the bandgap Ega of the base region is greater than the bandgap Egb of the emitter region, and the undoped layer is disposed between the base region and the emitter region, where the bandgap Egc of the undoped layer satisfies: Egb≤Egc≤Ega, Ega≠Egb.

In an embodiment of the present disclosure, the thicknesses of the emitter, base, and BSF layers are all different. Specifically, the emitter region is thicker than both the base region and the BSF layer, and the BSF layer is thicker than the base region.

The emitter region is N-type doped, while the base region is P-type doped. The doping concentration of the emitter region is lower than that of the base region.

It should be noted that, if the subcell group includes two subcells, a tunnel junction is provided between the two subcells. Among them, one subcell is a heterojunction subcell.

If the subcell group includes three or more subcells, tunnel junctions are provided between every two adjacent subcells. Additionally, between the last subcell and the preceding subcell, a metamorphic buffer layer is also provided between the tunnel junction and the last subcell. Among these subcells, one or more may be heterojunction subcells.

It should also be noted that the subcell group includes at least one non-heterojunction subcell.

In some embodiments of the present disclosure, when growing a heterojunction subcell using MOCVD, the emitter region of the heterojunction subcell is grown to be thicker than both the base region and the BSF layer, with the BSF layer being thicker than the base region. The bandgap of the BSF layer is greater than that of the base region.

Specifically, the emitter region is N-type doped, the base region is P-type doped, and the doping concentration of the emitter region is lower than that of the base region.

In some embodiments of the present disclosure, when growing a heterojunction subcell via MOCVD, the BSF layer is P-type doped with a doping concentration higher than that of the base region, and the bandgap Egd of the BSF layer is greater than the bandgap Ega of the base region.

In the present disclosure, by setting the thickness relationship between the base region and the BSF layer, the depletion region can extend into a portion of the BSF layer, thereby increasing the device voltage of the multi-junction solar cell.

In the multi-junction solar cell disclosed by embodiments of the present disclosure, at least one heterojunction subcell is grown during the preparation process. The bandgap Ega of the base region is greater than the bandgap Egb of the emitter region, and the bandgap Egc of the undoped layer lies between Ega and Egb. The emitter, base, and BSF layers are grown with different thicknesses. This structure can effectively prevent the redistribution of dopants within the subcell, ensuring stable solar cell performance and high conversion efficiency, thus achieving the objective of a multi-junction solar cell with high performance and efficiency.

Building on the above examples, the present disclosure further provides a preparation method for a multi-junction solar cell. The multi-junction solar cells disclosed in FIGs 1 to 5 can be fabricated using this method. The method includes the following steps:
S21: Provide a substrate (1).
S22: Using metal-organic chemical vapor deposition (MOCVD), sequentially grow on the substrate (1): an etch stop layer (2), an N-type ohmic contact layer (3), a first subcell (4), a first tunnel junction (5), a second subcell (6), a second tunnel junction (7), a metamorphic buffer layer (8), a third subcell (9), and a P-type ohmic contact layer (10).

In this embodiment, the first subcell (4) is an AlGaInP subcell, the second subcell (6) is a GaAs subcell, the third subcell (9) is an InGaAs subcell.

Between the emitter and base regions of any one or two of the subcells (4, 6, or 9), an undoped layer is provided. The thickness of the base region is less than that of the emitter and BSF layers. The bandgap relationship is, Egb≤Egc≤Ega and Ega≠Egb.

The emitter regions of the first, second, and third subcells are N-type doped. The base regions and BSF layers are P-type doped. The P-type doping concentration of the base region is lower than that of the BSF layer.

In the practical MOCVD growth process, step S22 includes:
Growing the etch stop layer (2) on the substrate (1).
Growing the N-type ohmic contact layer (3) on the etch stop layer (2).
Growing the first subcell (4) on the N-type ohmic contact layer (3).
Growing the first tunnel junction (5) on the first subcell (4).
Growing the second subcell (6) on the first tunnel junction (5).
Growing the second tunnel junction (7) on the second subcell (6).
Growing the metamorphic buffer layer (8) on the second tunnel junction (7).
Growing the third subcell (9) on the metamorphic buffer layer (8).
Growing the P-type ohmic contact layer (10) on the third subcell (9).

In an embodiment of the present disclosure of the present disclosure, when growing any of the first, second, or third subcells (4, 6, or 9) via MOCVD, the emitter region is made thicker than both the base and BSF layers, the base region is thinner than the BSF layer, and the bandgap of the BSF layer is greater than that of the base region.

In the preparation method for the multi-junction solar cell disclosed in embodiments of the present disclosure, by growing at least one heterojunction subcell during the growth of the multi-junction solar cell, so that the base region bandgap Ega of the heterojunction subcell is higher than the emitter region bandgap Egb, and so that the undoped layer bandgap Egc is in the middle between the base region bandgap Ega and the emitter region bandgap Egb. This configuration allows the depletion region to extend into the high-bandgap base region, thereby reducing non-radiative recombination and increasing the device voltage of the multi-junction solar cell. Moreover, a thick emitter region reduces resistance, effectively preventing redistribution of dopants within the subcell. This ensures the solar cell's performance and efficiency, thus achieving the goal of realizing a multi-junction solar cell with high efficiency and high performance. Furthermore, by designing the thickness relationship between the base region and the BSF layer, the depletion region can also extend into part of the BSF layer, which further improves the device voltage of the multi-junction solar cell.

The present disclosure also provides an electronic device equipped with the above-disclosed multi-junction solar cell, or with a multi-junction solar cell fabricated using the above-described method.

The various embodiments described in this specification are presented in a progressive, parallel, or combined manner. Each embodiment primarily highlights the distinctions from other embodiments. Shared or similar parts among the embodiments may be referenced interchangeably.

It should be noted that, in the description of the present disclosure, the drawings and embodiments are illustrative rather than limiting. The same reference numerals used across different embodiments in the specification refer to identical structures. Additionally, for clarity and ease of understanding, some layers, films, panels, or regions may be exaggerated in thickness in the figures. Moreover, it should be understood that when an element such as a layer, film, region, or substrate is described as being "on" another element, it may be directly on that element or may include an intermediate layer or structure. Furthermore, the term "on" may indicate that one element is positioned above or below another in a layout sense, rather than specifically according to gravity.

Directional or positional terms such as "upper," "lower," "top," "bottom," "inner," and "outer" are based on the orientations shown in the accompanying figures and are used merely for descriptive convenience and simplification. They are not intended to imply specific positional or structural limitations and should not be construed as restrictive to the application. When a component is described as being "connected" to another, it may be directly connected or indirectly connected through one or more intermediate components.

Additionally, relational terms such as "first" and "second" are used merely to distinguish between different elements or operations and do not imply any particular sequence or relationship unless otherwise indicated. Also, the terms "include," "comprise," or any variation thereof are intended to encompass a non-exclusive inclusion. An object or device described as including certain elements may also include other elements not explicitly listed, or may include inherent elements of the object or device. Without additional limitations, elements defined by statements such as "including a ..." do not exclude the presence of other similar elements in the item or device.

The above description of the disclosed embodiments enables those skilled in the art to implement or use the present disclosure. Various modifications to these embodiments will be apparent to those skilled in the art. The general principles defined herein may be applied to other embodiments without departing from the spirit or scope of the present disclosure. Therefore, the present disclosure is not limited to the embodiments shown herein, but is to be accorded the widest scope consistent with the principles and novel features disclosed.

## Claims

1. A multi-junction solar cell, **characterized in that** the multijunction solar cell comprises at least one heterojunction subcell, the heterojunction subcell comprising:
a window layer, an emitter region, an undoped layer, a base region, and a back surface field (BSF) layer;
wherein the bandgap Ega of the base region of the heterojunction subcell is greater than the bandgap Egb of the emitter region; the undoped layer is disposed between the base region and the emitter region, and the bandgap Egc of the undoped layer satisfies the relationship: Egb≤Egc≤Ega, and Ega≠Egb.multi-junction

2. The multi-junction solar cell according to claim 1, **characterized in that**, in the heterojunction subcell:
the thickness of the emitter region is greater than that of the base region and the BSF layer; the thickness of the BSF layer is greater than that of the base region;
the emitter region is N-type doped, the base region is P-type doped, and the doping concentration of the emitter region is lower than that of the base region.

3. The multi-junction solar cell according to claim 1, **characterized in that**, in the heterojunction subcell:
the BSF layer is P-type doped, and its doping concentration is higher than that of the base region;
the bandgap Egd of the BSF layer is greater than the bandgap Ega of the base region.

4. The multi-junction solar cell according to claim 1, **characterized in that**:
the thickness of the emitter region exceeds 500 nm, the thickness of the BSF layer is less than 400 nm, the thickness of the base region is less than 200 nm, and the thickness of the undoped layer is greater than 50 nm.

5. The multi-junction solar cell according to any one of claims 1 to 4, **characterized in that** the multi-junction solar cell comprises a plurality of heterojunction subcells, each formed of different materials, and in any one of the heterojunction subcells:
the window layer is formed of N-AlInP material;
the emitter region is formed of N-AlGaInP material;
the undoped layer is formed of I-AlGaInP material;
the base region is formed of P-AlGaInP material;
the BSF layer is formed of P-AlGaInP material.

6. The multi-junction solar cell according to any one of claims 1 to 4, **characterized in that** the multi-junction solar cell comprises a plurality of heterojunction subcells, each formed of different materials, and in any one of the heterojunction subcells:
the window layer is formed of GaInP, AlGaInP, or AlInP material;
the emitter region is formed of N-AlGaAs material;
the undoped layer is formed of I-AlGaAs material;
the base region is formed of P-AlGaAs or P-GaInP material;
the BSF layer is formed of P-AlGaAs or P-GaInP material.

7. The multi-junction solar cell according to any one of claims 1 to 4, **characterized in that** the multi-junction solar cell comprises a plurality of heterojunction subcells, each formed of different materials, and in any one of the heterojunction subcells:
the window layer is formed of GaInP or AlIn_{y}GaAs material;
the emitter region is formed of N-In_{y}GaAs or N-GaInP material;
the base region is formed of P-In_{y}GaAs material;
the BSF layer is formed of GaInP or AlIn_{y}GaAs material.

8. A method for fabricating a multi-junction solar cell, **characterized in that** the method comprises:
providing a substrate;
sequentially growing, on the substrate by metal-organic chemical vapor deposition (MOCVD), an etch stop layer, an N-type ohmic contact layer, at least one subcell group, and a P-type ohmic contact layer, wherein the subcell group comprises at least one heterojunction subcell;
the heterojunction subcell comprising: a window layer, an emitter region, an undoped layer, a base region, and a BSF layer;
wherein the bandgap Ega of the base region is greater than the bandgap Egb of the emitter region, the undoped layer is disposed between the base region and the emitter region, and the bandgap Egc of the undoped layer satisfies Egb≤Egc≤Ega and Ega≠Egb.

9. The method according to claim 8, **characterized in that**, during the MOCVD growth of the heterojunction subcell, the thickness of the emitter region is controlled to exceed that of the base region and the BSF layer, and the thickness of the BSF layer is greater than that of the base region;
wherein the emitter region is N-type doped, the base region is P-type doped, and the doping concentration of the emitter region is lower than that of the base region.

10. The method according to claim 8, **characterized in that**, during the MOCVD growth of the heterojunction subcell, the BSF layer is P-type doped, and its doping concentration is greater than that of the base region,
the bandgap Egd of the BSF layer is greater than the bandgap Ega of the base region.

11. An electronic device, **characterized in that** the electronic device is provided with the multi-junction solar cell according to any one of claims 1 to 7, or is provided with a multijunction solar cell fabricated using the method according to any one of claims 8 to 10.
